# EUROPEAN PATENT SPECIFICATION

(11) **EP 3 531 144 B1**
(45) Date of publication and mention of the grant of the patent: **19.08.2020**
(21) Application number: 18382116.4
(22) Date of filing: 27.02.2018
(51) Int. Cl.: G01R 29/18, H02J 13/00

(54) **METHOD AND SYSTEM FOR CONNECTIVITY DETECTION IN AN ELECTRIC POWER DISTRIBUTION NETWORK**
VERFAHREN UND SYSTEM ZUR ERKENNUNG VON KONNEKTIVITÄTEN IN EINEM ELEKTRISCHEN STROMVERTEILUNGSNETZ
PROCÉDÉ ET SYSTÈME DE DÉTECTION DE CONNECTIVITÉS DANS UN RÉSEAU DE DISTRIBUTION ÉLECTRIQUE

(43) Date of publication of application: 28.08.2019
(73) Proprietor: Ariadna Instruments, S.L., 48340 Amorebieta (ES); Merytronic 2012, SL, 48340 Amorebieta (ES)
(72) Inventor: ZUBIA URRUTIA, Haritz, 48940 LEIOA (ES)
(74) Representative: Juncosa Miró, Jaime

(56) References cited:
- AU-B2- 2014 219 246
- US-A1- 2015 010 093
- US-A1- 2016 109 491

## Description

### Technical Field

The present invention generally relates to the field of systems for detecting loads connected in a low- or medium-voltage electrical power grid. In particular, the present invention relates to a method and system for detecting connectivities in an electrical power distribution grid after an active injection of signals.

### Background

A method for identifying connectivities in power grids is known by means of patent document EP-B1-3032269 belonging to the same applicant of the present invention. The method allows detecting and recording the connectivity of end consumers by recording the consumption patterns generated by the loads, measured by each client meter, and then said consumption patterns are compared with second records of consumptions that are measured at the head ends of the grid (lines, transformer output, etc.). The records are based on currents generated by the actual end consumer, and since they are not expressly produced for detecting connectivity they are referred to as passive signals, i.e., it is an electric current that has not been injected into or circulated in the electric power grid for the purpose of carrying out the identification of connectivities. A passive electric current is a current associated with an unforced energy consumption by a load.

On the other hand, in order to detect connectivities in power grids, it is also known that an operator, whose job it is to check and record the connectivities of client meters in the field, injects a signal close to the client meter, and another head end apparatus installed at the head end of the lines or next to the transformer, with sensors in each distribution line, detects through which one it arrives. The mentioned head end apparatus then transmits the result to equipment of the operator, said equipment of the operator being connected close to the meter through the actual electric power grid so the operator can view said result and record it. Since dedicated signals put into the grid are used in this mode, it is a system based on active signals. In this case, for detecting connectivities there has to be direct communication between the receiving equipment of the operator and the apparatus/equipment installed at the head end of the lines or in the transformer.

The types of dedicated communication that normally use apparatus of this type are usually point-to-point communication, such as power-line communication (PLC) and radio communication.

Each type of communication has associated problems:
- PLC:
   ∘ In LV grids, there may be a lack of service at points far away from Transformer Substation;
   ∘ In MV grids, injecting a signal into cables is complicated (expensive and bulky couplers, as well as insulated cables, are required);
   ∘ The usable band spectrum varies according to countries, and in many cases they are not the most suitable for communicating data over distances of hundreds of meters.
- Radio:
   ∘ There are service problems when accessing meter rooms, when transformation substations are underground, etc.

Therefore, there is a need for methods for detecting connectivities based on the active injection of signals and alternative communications when there is no direct communication between the equipment injecting the signal and the equipment detecting it.

Further relevant prior art can be found in US 2016/109491 A1, US 2015/010093 A1 and AU 2014 219 246 B2.

### Description of the Invention

To that end, embodiments of the present invention provide, according to a first aspect, a method according to claim 1 for detecting connectivities in an electrical power distribution grid, wherein the mentioned electrical power distribution grid comprises a series of electrical power distribution lines, with each electrical power distribution line having a series of load connection points connected thereto, and each load connection point including at least one client meter.

Unlike the methods known in the state of the art, in the proposed method, first a code signal having a given duration and being synchronized with a carrier signal of the power grid (i.e., 50 or 60 Hz) is injected by means of test equipment located in the connection of a client meter, selected from said series of load connection points. The mentioned test equipment is portable, has the capacity to determine its geolocation (i.e., it includes means/units that are specific for such purpose), preferably in a dynamic manner, for example, automatically by a GPS/GALILEO/GLONASS-type system, or by manually entering the address, the position on a map, etc., and it includes a clock synchronized with an external server. The test equipment also acquires information relating to its geolocation, as well as the instant in time in which it injected the code signal, generating a signal injection record, and it sends the generated signal injection record together with information relating to the connection point where the code signal has been injected, for example a serial number of the client meter, a connection identifier, information about the position of the connection point such as an address, position on a map, geolocation, etc., to a remote computation server by means of a communication unit thereof, preferably by means of wireless communication. This signal injection record may be sent in the very instant in which the code signal was injected if there is a connection with the remote computation server, or may be saved in a memory for subsequent dumping at a later time when communication exists.

Receiving equipment located at the head end of the electrical power distribution grid, with a clock synchronized with the mentioned external server and with a known geolocation, detects the code signal injected by one of the line and phase cables which monitors and acquires the instant in time in which it detected the code signal, generating a signal detection record. The receiving equipment also sends the generated signal detection record to the mentioned computation server, preferably also via a wireless communication through a communication unit thereof (at the same instant or later, depending on the availability of communication).

Upon receiving the signal injection record and signal detection record, the computation server thereby matches them up, for example, by means of executing/implementing a matching algorithm, for correlating the connection point with a given a transmission line and a given head end and thereby identifying connectivity conditions of the mentioned connection point.

A simple, non-limiting matching algorithm which can be implemented by the computation server may consist of, upon the arrival of a detection record from the head end equipment (i.e., from the receiving equipment), the computation server waiting to receive an injection record from a location close to the head end equipment, for example, in a radius of 1 km in the case of low-voltage grids. The computation server in this case may wait for a given time, for example, several days, until receiving the injection record, in case the portable test equipment had communication problems.

Once the two records are received, if the temporary records coincide and come from places close to one another, the computation server can relate the information relating to the connection point where the code signal has been injected with the electrical position (transformer substation, line and phase) where the transmission was detected. In one embodiment, the mentioned code signal is a transient current signal. The code signal may comprise current pulses having a duration between 0.1 milliseconds and several entire grid cycles (of 50 or 60 Hz). Preferably, the duration of the current pulses is 2 milliseconds.

In one embodiment, the duration of the current pulses is fixed.

Alternatively, the code signal may comprise several bits of information containing at least one identifier of the test equipment. Preferably, the number of bits will be low and overheating of the test equipment is thereby prevented.

In one embodiment, the method further comprises sending a result of the calculated connectivity conditions to the test equipment by means of the computation server.

Embodiments of the present invention provide, according to a second aspect, a system according to claim 11 for detecting connectivities in an electrical power distribution grid. The system of the second aspect of the invention is configured for implementing the different steps and embodiments of the method of the first aspect of the invention.

The proposed system comprises a remote computation server including one or more processors and at least one memory; a portable test equipment having the capacity to determine its geolocation and including a clock synchronized with an external server, said test equipment being located in the connection of a client meter, selected from a series of load connection points of an electrical power grid, and including a communication unit; and a receiving equipment located at the head end of the electrical power distribution grid, including a clock also synchronized with the external server and a communication unit. The receiving equipment does not have direct communication with the test equipment. The mentioned computation server may comprise several servers or be distributed in several points. The computation server may also be physical or virtual, i.e., be implemented in the cloud.

In the proposed system, the test equipment is arranged and configured for: injecting a code signal having a given duration and synchronized with a carrier signal of the power grid; acquiring information referring to its geolocation and the instant in time in which it injected said code signal, generating a signal injection record; and sending the generated signal injection record together with information relating to the connection point where the code signal has been injected to the computation server. The receiving equipment is likewise arranged and configured for: detecting the injected code signal; acquiring the instant in time in which it detected the code signal, generating a signal detection record; and sending said signal detection record to the computation server. With the received signal injection record and signal detection record, the computation server, through the processor(s), can relate the mentioned connection point with a given transmission line and a given head end, and identifying connectivity conditions of the mentioned connection point.

By means of this arrangement of test equipment, receiving equipment, and server (or servers), where the connectivity is calculated, a more effective action is assured in all cases without depending on direct communication between the operator and a head end point.

Other embodiments of the invention which are described herein also include computer software programs for carrying out the steps and operations of the method proposed in the first aspect of the invention. More particularly, a computer software program is an embodiment having a computer-readable medium that includes computer program instructions encoded therein which, when executed in at least one processor of a computer system, make the processor perform the operations indicated herein as embodiments of the invention.

### Brief Description of the Drawings

The foregoing and other advantages and features will be better understood based on the following detailed description of embodiments in reference to the attached drawings, which must be interpreted in an illustrative and non-limiting manner, in which:
Fig. 1 schematically shows a system for detecting connectivities in an electrical power distribution grid according to an embodiment of the present invention.
Figs. 2A, 2B and 2C illustrate different embodiments of the code signal which can be injected by the test equipment.

### Detailed Description of Several Embodiments

The present invention provides a method and system for detecting connectivities in an electrical power distribution grid, particularly based on the injection of active signals.

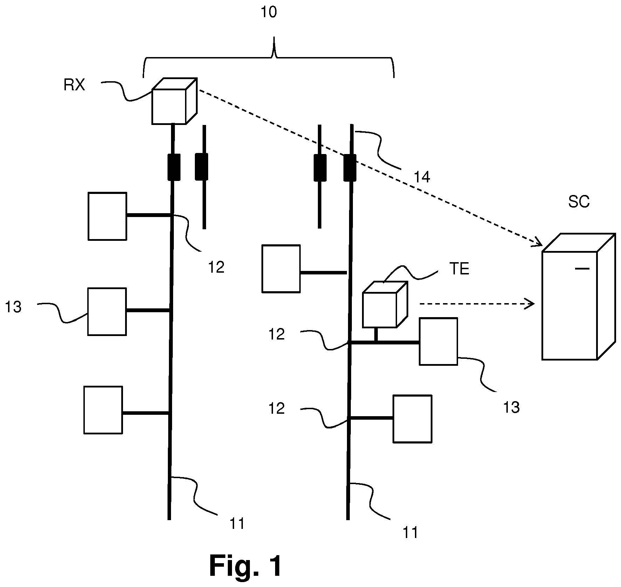

Fig. 1 shows an embodiment of the proposed system. As can be seen in said figure, the system is implemented in an either low-voltage or medium-voltage electrical power distribution grid 10, comprising a series of electrical power distribution lines 11. Each electrical power distribution line 11 has a series of load connection points 12 associated therewith, each load connection point 12 including several client meters 13.

In the proposed system, a portable test equipment TE is located in the connection of a client meter 13, i.e., downstream of the electrical power distribution grid 10, close to the point the connectivity of which is to be known. On one hand, a receiving equipment RX is located at the head end 14 of the electrical power distribution grid 10, i.e., at the point with respect to which the connectivity is to be referenced. The receiving equipment RX is configured with the test equipment TE, preferably via an internal clock included in both receiving and test equipment and synchronized with a common external server (not illustrated in the drawing). Both the test equipment TE and receiving equipment RX can set up communication, preferably wireless communication, with a computation server SC through respective communication units.

In addition to being portable and including the mentioned clock, the test equipment TE is also provided with means/units having the capacity to determine its geolocation, preferably in a dynamic manner, for example, automatically by a GPS/GALILEO/GLONASS system, or manually.

For detecting the connectivity of the mentioned point, the test equipment TE injects a code signal, such as a transient current signal, having a duration of between 0.1 ms up to several grid cycles (20 ms at 50 Hz, 16.6 ms at 60 Hz), preferably of 2 milliseconds, and synchronized with a carrier signal of the power grid (i.e., at 50-60 Hz), acquiring (or tagging) its geolocation and the instant in time in which it injected the code signal, and accordingly generating a signal injection record. The test equipment TE also sends the signal injection record that it generated together with information relating to the connection point where the code signal has been injected, for example, serial number of the meter 13, address, geolocation information, etc., to the mentioned computation server SC.

In turn, the receiving equipment RX can detect the code signal injected by the test equipment TE and acquire (or tag) the instant in time in which it detected the code signal, generating a signal detection record. The signal detection record is sent to the mentioned computation server SC by means of the receiving equipment RX.

With the received information, the computation server SC correlates the connection point with a given a transmission line and a given head end, and identifies the connectivity conditions of the mentioned connection point. For that purpose, the computation server will execute an algorithm which matches up both the signal injection record and the signal detection record by means of one or more of its processors in general. The result can be sent to the test equipment TE so that, for example, an operator can verify the correct execution of the process of identifying connectivity.

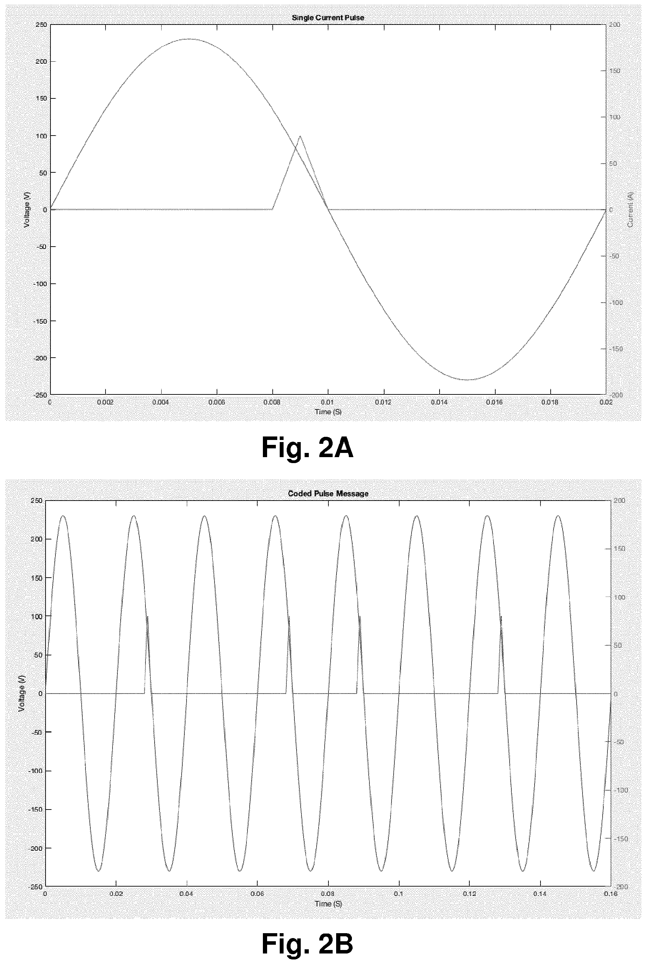

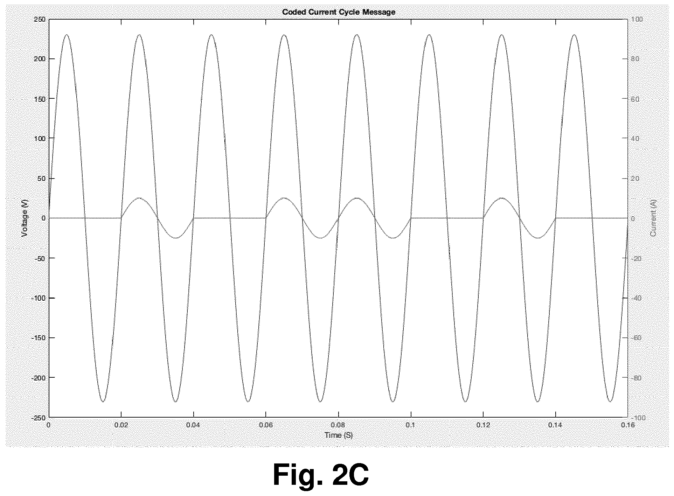

Now in reference to Fig. 2 (see Figs. 2A, 2B and 2C), different embodiments of the code signal that can be injected by the test equipment TE are shown therein. In these particular embodiments, the code signal is made up of several current pulses (or cycles), where 0 indicates that there was no pulse and 1 indicates that a pulse has been injected. For example, one code could be [0 1 0 1 1 0 1 0].

Since current pulses contain a great deal of energy for being detected at the head end 14 of the electrical power distribution grid 10, a large number of them for encoding information will preferably not be transmitted, since the test equipment TE may become overheated, which would entail having to have larger and more expensive test equipment, and since it is portable equipment, having to be larger would be a drawback. Therefore, in the proposed system the injected code signal will be fixed or it will simply encode a few bits or bytes of information, in order to transmit, for example, an identifier of the test equipment TE. Due to these restrictions concerning the quantity of the code signal to be injected, encoding data about the point where the signal is injected, such as the serial number of the meter 13 to be identified, the address of the location, geolocation information, etc., is not considered suitable.

The receiving equipment RX may also include a system for discriminating the code signal from the other passive currents flowing through the electrical power distribution grid 10.

In an alternative embodiment, it is envisaged that both the test equipment and the receiving equipment do not send the respective signal injection record and signal detection record to the computation server SC, but rather it is the computation server SC or another computation device that is connected to both pieces of equipment (test equipment and receiving equipment) in order to consult the data acquired and then perform the match.

In the present memory, the word "comprises", "includes", etc., and variants thereof, such as "comprising", "including", etc., must not be interpreted in an exclusive manner, i.e., the use of those terms does not exclude the possibility that the invention as described above may include other elements, steps, etc.

Furthermore, the invention is not limited to the specific embodiments described herein, but rather it also covers, for example, variants thereof which may be carried out by one skilled in the art, for example, with respect to the election of materials, dimensions, components, configurations, etc., without departing from the scope of the invention such as it is defined in the attached claims.

## Claims

1. A method for detecting connectivities in an electrical power distribution grid, wherein said electrical power distribution grid (10) comprises a series of electrical power distribution lines (11), with each electrical power distribution line (11) having a series of load connection points (12) connected thereto, each load connection point (12) including at least one client meter (13), wherein the method comprises:
- injecting a code signal having a given duration and synchronized with a carrier signal of the power grid into a line of said electrical power distribution grid (10) by means of at least one portable test equipment (TE) having the capacity to determine its geolocation and a clock synchronized with an external server, located in the connection of a client meter (13), selected from said series of load connection points (12);
- acquiring, by said test equipment (TE), information referring to its geolocation and the instant in time in which it injected said code signal, generating a signal injection record, and sending said generated signal injection record together with information relating to the connection point where the code signal has been injected to a remote computation server (SC) by means of a communication unit of the test equipment (TE);
- detecting the code signal by a receiving equipment (RX) located at the head end (14) of the electrical power distribution grid (10), or at least upstream of the point where the test equipment (TE) is located, having the capacity to determine its geolocation and a clock synchronized with said external server;
- acquiring, by the receiving equipment (RX), the instant in time in which it detected the code signal, generating a signal detection record, and sending said generated signal detection record to said computation server (SC) by means of a communication unit of the receiving equipment (RX); and
- matching up said signal injection record and signal detection record by said computation server (SC) for correlating the connection point with a given a transmission line and a given head end, and identifying connectivity conditions of the mentioned connection point.

2. The method according to claim 1, wherein said code signal is a transient current signal.

3. The method according to claim 2, wherein the code signal comprises current pulses having a duration between 0.1 milliseconds and several entire grid cycles.

4. The method according to any one of the preceding claims, wherein the duration of the current pulses is fixed.

5. The method according to claim 3 or 4, wherein the duration of the current pulses is 2 milliseconds.

6. The method according to claim 2, wherein the code signal comprises several bits of information containing at least one identifier of the test equipment (TE).

7. The method according to claim 1, wherein the information relating to the connection point comprises information about the connection point including a serial number of the client meter (13) and/or a connection identifier, and information about the position of the connection point including the address, the position on a map, and/or geolocation.

8. The method according to any one of the preceding claims, wherein the method further comprises sending a result of said connectivity conditions to the test equipment (TE) by means of said computation server (SC).

9. The method according to claim 1 or 7, wherein the injection of the code signal and the sending of the generated signal injection record together with the information relating to the connection point are performed at the same time.

10. The method according to claim 1 or 7, wherein the method further comprises storing the generated signal injection record in a memory of the test equipment (TE) prior to the sending thereof.

11. A system for detecting connectivities in an electrical power distribution grid, wherein said electrical power distribution grid (10) comprises a series of electrical power distribution lines (11), with each electrical power distribution line (11) a having series of load connection points (12) connected thereto, each load connection point (12) including at least one client meter (13), wherein the system comprises:
- a remote computation server (SC) including one or more processors and at least one memory;
- a portable test equipment (TE) having the capacity to determine its geolocation and including a clock synchronized with an external server, said test equipment (TE) being located in the connection of a client meter (13), selected from said series of load connection points (12), configured for injecting a code signal having a given duration and synchronized with a carrier signal of the power grid, acquiring information referring to its geolocation and the instant in time in which it injected said code signal, generating a signal injection record, and said test equipment (TE) including a communication unit configured for sending said signal injection record together with information relating to the connection point where the code signal has been injected to said computation server (SC); and
- a receiving equipment (RX) located at the head end (14) of the electrical power distribution grid (10), or at least upstream of the point where the test equipment (TE) is located, having the capacity to determine its geolocation and including a clock synchronized with said external server, said receiving equipment (RX) being configured for detecting the code signal and acquiring the instant in time in which it detected the code signal, generating a signal detection record, and said receiving equipment (RX) including a communication unit configured for sending said signal detection record to the computation server (SC),
wherein said one or more processors of the computation server (SC) are configured for matching up the signal injection record and signal detection record for correlating said connection point with a given a transmission line and a given head end, and identifying connectivity conditions of the mentioned connection point.

## Patentansprüche

1. Verfahren zum Erfassen von Konnektivitäten in einem Stromverteilungsnetz, wobei das Stromverteilungsnetz (10) eine Reihe von Stromverteilungsleitungen (11) umfasst, wobei jede Stromverteilungsleitung (11) eine Reihe von Lastanschlusspunkten (12) aufweist, die an diese angeschlossen sind, wobei jeder Lastanschlusspunkt (12) mindestens einen Kundenzähler (13) aufweist, wobei das Verfahren Folgendes umfasst:
- Eingeben eines Codesignals, das eine gegebene Dauer aufweist und mit einem Trägersignal des Stromnetzes synchronisiert ist, in eine Leitung des Stromverteilungsnetzes (10) durch mindestens ein tragbares Testgerät (TE), das die Fähigkeit besitzt, seine Geolokation zu bestimmen, und einen Takt aufweist, der mit einem externen Server synchronisiert ist, der in dem Anschluss eines Kundenzählers (13) liegt, der aus einer Reihe von Lastanschlusspunkten (12) ausgewählt ist;
- Erhalten durch das Testgerät (TE) von Informationen bezüglich seiner Geolokation und des Zeitpunkts, zu welchem es das Codesignal eingegeben hatte, Erzeugen einer Signaleingabeaufzeichnung und Senden der erzeugten Signaleingabeaufzeichnung zusammen mit Informationen bezüglich des Anschlusspunkts, wo das Codesignal eingegeben worden ist, zu einem entfernten Rechenserver (SC) durch eine Kommunikationseinheit des Testgeräts (TE);
- Erfassen des Codesignals durch ein Empfangsgerät (RX), das an dem Kopfende (14) des Stromverteilungsnetzes (10) oder mindestens stromaufwärts des Punkts, wo das Testgerät (TE) liegt, liegt, das die Fähigkeit besitzt, seine Geolokation zu bestimmen, und einen Takt aufweist, der mit dem externen Server synchronisiert ist;
- Erhalten durch das Empfangsgerät (RX) des Zeitpunkts, zu welchem es das Codesignal erfasste, Erzeugen einer Signalerfassungsaufzeichnung und Senden der erzeugten Signalerfassungsaufzeichnung zu dem Rechenserver (SC) durch eine Kommunikationseinheit des Empfangsgeräts (RX); und
- Zusammenbringen der Signaleingabeaufzeichnung und der Signalerfassungsaufzeichnung durch den Rechenserver (SC) zum Korrelieren des Anschlusspunkts mit einer gegebenen Übertragungsleitung und einem gegebenen Kopfende und Kennzeichnen von Konnektivitätsbedingungen des genannten Anschlusspunkts.

2. Verfahren nach Anspruch 1, wobei das Codesignal ein Übergangsstromsignal ist.

3. Verfahren nach Anspruch 2, wobei das Codesignal Stromimpulse umfasst, die eine Dauer zwischen 0,1 Millisekunden und mehreren ganzen Netzzyklen aufweist.

4. Verfahren nach einem der vorherigen Ansprüche, wobei die Dauer der Stromimpulse fix ist.

5. Verfahren nach Anspruch 3 oder 4, wobei die Dauer der Stromimpulse 2 Millisekunden beträgt.

6. Verfahren nach Anspruch 2, wobei das Codesignal mehrere Bits an Informationen umfasst, die mindestens eine Kennung des Testgeräts (TE) enthalten.

7. Verfahren nach Anspruch 1, wobei die Informationen bezüglich des Anschlusspunkts Informationen über den Anschlusspunkt einschließlich einer Seriennummer des Kundenzählers (13) und/oder einer Anschlusskennung und Informationen über die Position des Anschlusspunkts einschließlich der Adresse, der Position auf einer Karte und/oder der Geolokation umfassen.

8. Verfahren nach einem der vorherigen Ansprüche, wobei das Verfahren ferner das Senden eines Ergebnisses der Konnektivitätsbedingungen zu dem Testgerät (TE) durch den Rechenserver (SC) umfasst.

9. Verfahren nach Anspruch 1 oder 7, wobei das Eingeben des Codesignals und das Senden der erzeugten Signaleingabeaufzeichnung zusammen mit den Informationen bezüglich des Anschlusspunkts gleichzeitig durchgeführt werden.

10. Verfahren nach Anspruch 1 oder 7, wobei das Verfahren ferner das Speichern der erzeugten Signaleingabeaufzeichnung in einem Speicher des Testgeräts (TE) vor dem Senden davon umfasst.

11. System zum Erfassen von Konnektivitäten in einem Stromverteilungsnetz, wobei das Stromverteilungsnetz (10) eine Reihe von Stromverteilungsleitungen (11) umfasst, wobei jede Stromverteilungsleitung (11) eine Reihe von Lastanschlusspunkten (12) aufweist, die an diese angeschlossen sind, wobei jeder Lastanschlusspunkt (12) mindestens einen Kundenzähler (13) aufweist, wobei das System Folgendes umfasst:
- einen entfernten Rechenserver (SC), der einen oder mehrere Prozessoren und mindestens einen Speicher aufweist;
- ein tragbares Testgerät (TE), das die Fähigkeit besitzt, seine Geolokation zu bestimmen, und einen Takt aufweist, der mit einem externen Server synchronisiert ist, wobei das Testgerät (TE) in dem Anschluss eines Kundenzählers (13) liegt, der aus einer Reihe von Lastanschlusspunkten (12) ausgewählt ist, das zum Eingeben eines Codesignals, das eine gegebene Dauer aufweist und mit einem Trägersignal des Stromnetzes synchronisiert ist, Erhalten von Informationen bezüglich seiner Geolokation und des Zeitpunkts, zu welchem es das Codesignal eingab, Erzeugen einer Signaleingabeaufzeichnung konfiguriert ist, und wobei das Testgerät (TE) eine Kommunikationseinheit aufweist, die zum Senden der Signaleingabeaufzeichnung zusammen mit Informationen bezüglich des Anschlusspunkts, wo das Codesignal eingegeben worden ist, zu dem Rechenserver (SC) konfiguriert ist; und
- ein Empfangsgerät (RX), das an dem Kopfende (14) des Stromverteilungsnetzes (10) oder mindestens stromaufwärts des Punkts, wo das Testgerät (TE) liegt, liegt, das die Fähigkeit besitzt, seine Geolokation zu bestimmen, und einen Takt aufweist, der mit dem externen Server synchronisiert ist, wobei das Empfangsgerät (RX) zum Erfassen des Codesignals und Erhalten des Zeitpunkts, zu welchem es das Codesignal erfasste, Erzeugen einer Signalerfassungsaufzeichnung konfiguriert ist, und wobei das Empfangsgerät (RX) eine Kommunikationseinheit aufweist, die zum Senden der Signalerfassungsaufzeichnung zu dem Rechenserver (SC) konfiguriert ist,
wobei der eine oder die mehreren Prozessoren des Rechenservers (SC) zum Zusammenbringen der Signaleingabeaufzeichnung und der Signalerfassungsaufzeichnung zum Korrelieren des Anschlusspunkts mit einer gegebenen Übertragungsleitung und einem gegebenen Kopfende und Kennzeichnen von Konnektivitätsbedingungen des genannten Anschlusspunkts konfiguriert sind.

## Revendications

1. Une méthode pour détecter des connectivités dans un réseau de distribution d'énergie électrique, dans laquelle ce réseau de distribution d'énergie électrique (10) comporte une série de lignes de distribution d'énergie électrique (11), chaque ligne de distribution d'énergie électrique (11) ayant une série de points de connexion de charge (12) qui y sont connectés, chaque point de connexion de charge (12) comprenant au moins un compteur de client (13), où la méthode comporte :
- injecter un signal code ayant une certaine durée et synchronisé avec un signal porteur du réseau d'énergie dans une ligne de ce réseau de distribution d'énergie électrique (10) au moyen d'au moins un équipement de test portable (TE) ayant la capacité de déterminer sa géolocalisation et une horloge synchronisée avec un serveur externe, situé dans la connexion d'un compteur de client (13) sélectionné parmi cette série de points de connexion de charge (12) ;
- acquérir, par le biais de cet équipement (TE), des informations concernant sa géolocalisation et le moment dans le temps dans lequel il a injecté ce signal code, en générant un enregistrement d'injection de signal et en envoyant cet enregistrement d'injection de signal généré ensemble avec les informations concernant le point de connexion où le signal code a été injecté à un serveur informatique à distance (SC) au moyen d'une unité de communication de l'équipement de test (TE) ;
- détecter le signal code au moyen d'un équipement récepteur (RX) situé à la tête (14) du réseau de distribution d'énergie électrique (10), ou au moins en amont du point où l'équipement de test (TE) est situé, ayant la capacité de déterminer sa géolocalisation et une horloge synchronisée avec ledit serveur externe ;
- acquérir, par le biais de l'équipement récepteur (RX), le moment dans le temps dans lequel il a détecté le signal code, en générant un enregistrement de détection de signal et en envoyant cet enregistrement de détection de signal généré à ce serveur informatique (SC) au moyen d'une unité de communication de l'équipement récepteur (RX) ; et
- combiner cet enregistrement d'injection de signal et cet enregistrement de détection de signal par ce serveur informatique (SC) pour la corrélation du point de connexion avec une certaine ligne de transmission et une certaine tête et identifier les conditions de connectivité de ce point de connexion.

2. La méthode conformément à la revendication 1, dans laquelle ce signal code est un signal de courant transitoire.

3. La méthode conformément à la revendication 2, dans laquelle le signal code comporte des impulsions de courant ayant une durée entre 0,1 millisecondes et plusieurs cycles complets de réseau.

4. La méthode conformément à une quelconque des revendications précédentes, dans laquelle la durée des impulsions de courant est fixe.

5. La méthode conformément à la revendication 3 ou 4, dans laquelle la durée des impulsions de courant est de 2 millisecondes.

6. La méthode conformément à la revendication 2, dans laquelle le signal code comporte plusieurs bits d'information contenant au moins un identifiant de l'équipement de test (TE).

7. La méthode conformément à la revendication 1, dans laquelle les informations concernant le point de connexion comportent des informations concernant le point de connexion comprenant un numéro de série du compteur de client (13) et/ou un identifiant de connexion, et des informations concernant la position du point de connexion comprenant l'adresse, la position dans une carte, et/ou la géolocalisation.

8. La méthode conformément à une quelconque des revendications précédentes, dans laquelle la méthode comporte en plus l'envoi d'un résultat de ces conditions de connectivité à l'équipement de test (TE) au moyen de ce serveur informatique (SC).

9. La méthode conformément à la revendication 1 ou 7, dans laquelle l'injection du signal code et l'envoi de l'enregistrement d'injection de signal généré ensemble avec les informations concernant le point de connexion sont effectués en même temps.

10. La méthode conformément à la revendication 1 ou 7, dans laquelle la méthode comporte en plus le stockage de l'enregistrement d'injection de signal généré dans une mémoire de l'équipement de test (TE) avant de l'envoyer.

11. Un système pour détecter des connectivités dans un réseau de distribution d'énergie électrique dans lequel ce réseau de distribution d'énergie électrique (10) comporte une série de lignes de distribution d'énergie électrique (11), chaque ligne de distribution d'énergie électrique (11) ayant une série de points de connexion de charge (12) qui y sont connectés, chaque point de connexion de charge (12) comprenant au moins un compteur de client (13), où le système comporte :
- un serveur informatique à distance (SC) comprenant un ou plusieurs processeurs et au moins une mémoire ;
- un équipement de test portable (TE) ayant la capacité de déterminer sa géolocalisation et comprenant une horloge synchronisée avec un serveur externe, cet équipement de test (TE) étant situé dans la connexion d'un compteur de client (13) sélectionnée parmi cette série de points de connexion de charge (12), configurée pour injecter un signal code ayant une certaine durée et synchronisé avec un signal porteur du réseau d'énergie, acquérant des informations concernant sa géolocalisation et le moment dans le temps dans lequel il a injecté ce signal code, générant un enregistrement d'injection de signal et cet équipement de test (TE) comprenant une unité de communication configurée pour envoyer cet enregistrement d'injection de signal ensemble avec les informations concernant le point de connexion où le signal code a été injecté à ce serveur informatique (SC) ; et
- un équipement récepteur (RX) situé à la tête (14) du réseau de distribution d'énergie électrique (10), ou au moins en amont du point où l'équipement de test (TE) est situé, ayant la capacité de déterminer sa géolocalisation et comprenant une horloge synchronisée avec ce serveur externe, cet équipement récepteur (RX) étant configuré pour détecter le signal code et acquérir le moment dans le temps dans lequel il a détecté le signal code, en générant un enregistrement de détection de signal et cet équipement récepteur (RX) comprenant une unité de communication configurée pour envoyer cet enregistrement de détection de signal au serveur informatique (SC) ;
où cet un ou ces plusieurs processeurs du serveur informatique (SC) sont configurés pour combiner l'enregistrement d'injection de signal et l'enregistrement de détection de signal pour la corrélation de ce point de connexion avec une certaine ligne de transmission et une certaine tête, et identifiant les conditions de connectivité de ce point de connexion.
